# EUROPEAN PATENT APPLICATION

(11) **EP 1 202 193 A2**
(43) Date of publication of application: **02.05.2002**
(21) Application number: 01250341.3
(22) Date of filing: 27.09.2001
(51) Int. Cl.: G06F 17/50

(54) **Apparatus and method for verifying a logic function of a semiconductor chip**

(30) Priority: 28.10.2000 KR 2000063713
(71) Applicant: Dynalith Systems Co., Ltd, Kangnam-gu, Seoul 135-280 (KR)
(72) Inventor: Kyung, Chong Min, Taejon City 305-333 (KR); Ki, An Do, Taejon City 305-333 (KR); Lee, Seung Jong, Ilsan-gu, Koyang City Kyungki-do 411-372 (KR); Jeon, Young Wook, Taejon City 302-120 (KR)
(74) Representative: Hengelhaupt, Jürgen D., Dipl.-Ing.

(57) **Abstract**

An apparatus and method for verifying a logic function of a semiconductor chip in a logic chip emulation environment where a processing engine and a target interface engine interact with each other. The apparatus in accordance with the present invention generally includes a processing engine for executing a software algorithm corresponding to the logic design of the target chip, and a target interface engine interfacing with the target system for transmitting/receiving pin signals to/from the target system. The software algorithm has one or more software variables, and the transmission/reception of the pin signals by the target interface engine occurs with the execution of the software algorithm by the processing engine. The software variable and the pin signals are time-variant with the execution of the algorithm. The processing engine comprises means for finding correspondence between the software variables and the pin signals at a predetermined time, so that the values of the software variables and the values of the hardware pin signals corresponding in time thereto can be monitored in synchronization with each other.

## Description

The present invention relates generally to emulating a logic function of a semiconductor chip, and more particularly, to verifying a logic function of a semiconductor chip through emulation based on a software algorithm or model that defines an internal logic design of the semiconductor chip.

A successful design of a semiconductor chip incorporating an integrated circuit requires ever-increasing efforts and time as the complexity of such chips and those systems integrating such chips have increased drastically. Since it is desirable to eliminate the design errors in a design procedure before fabrication of such chips, verification of the logic design of the chip is much needed. Among various methods of verification is an emulation method that tries to verify the functional correctness of a logic function (hereinafter, referred to as "target logic") designed for a semiconductor chip ("target chip") in conjunction with an application system ("target system") in which the target chip will be used.

Traditionally, verification of a logic function has been performed by software or hardware modeling or a combination of the two. Among these, software modeling describes the behavior of the logic function of the target chip through software written in either a high-level programming language such as C/C++ or a hardware description language (HDL) such as VHDL and Verilog. However, HDL does not lend itself to a viable description or debugging of the logic function of the target chip compared to a high-level programming language, and speed of execution of hardware models coded in HDL is very limited. Thus, HDL is known to have disadvantages associated with time spent in designing and verifying the logic function.

For the above reasons, a software programming language, which is easier to code and debug and runs faster compared to HDL, is preferably used in modeling the logic function of the target chip. According to software modeling based on a high-level programming language, the logic function of the target chip is first modeled and the functional behavior of the logic is verified in conjunction with the surrounding hardware system or a target system. Thereafter, the logic is partitioned manually or possibly with some automatic means into parts to be implemented as hardware and software, respectively. This approach would significantly save the design and verification time, compared to the conventional HDL-based emulation method, and provide more efficient emulation environment for such cases where a logic design becomes extremely complex, especially with the growth of "System-on-a-Chip."

U.S. Patent No. 4,901,259 discloses an "ASIC emulator" which enables software models implemented in a high-level programming language as well as those in HDL to be run on a general-purpose computer connected to a target system via interface. It is basically a generalized pin I/O synchronizer that provides synchronization of pin signals produced by an ASIC software model, which is running on a general-purpose computer, with pin signals produced by hardware in a target system. In other words, all the pin signals for interface with the target system are produced by an ASIC software model, while the ASIC emulator converts the pin signal values into electrical signals in order to send the values to an ASIC bare socket in the target system.

However, when a fast emulation is needed, "ASIC emulator" described in U.S. Patent No. 4,901,259 presents several problems. First, a software model in the host computer is too slow to execute the whole process related to the generation of pin signals used for interface with external circuits. Second, the communication speed through an I/O port of a full-fledged host computer is generally very slow as compared with a processor speed. Third, the host computer is too slow to run the algorithm of an ASIC software model because it uses a general-purpose operating system that cannot dedicate its computing resources solely to running the algorithm. Therefore, such ASIC emulator cannot facilitate a variety of VLSI designs requiring fast emulation.

In order to solve these prior art problems, the inventors of the present invention proposed, in U.S. Patent Application No. 09/680,467, incorporated herein by reference, an in-circuit emulator which enables fast verification of the logic function of a target chip modeled in a high-level programming language such as C or C⁺⁺ at a system level where the target chip is coupled to the target system. The emulator comprises a processing engine including at least one processor that executes a compiled code of an algorithm written in a high-level programming language and a target interface engine including at least one reconfigurable chip, such as Field-Programmable Gate Arrays (FPGAs) or Programmable Logic Devices (PLDs), which generates pin signals used for external interface with the target system.

With this emulator, however, the processing engine and the target interface engine may be operating at different processing speeds and a communication delay may occur between the processing engine and the target interface engine due to an interface therebetween. In other words, a change in a software variable during execution of the compiled algorithm may not necessarily correspond to pin signals generated at the time of the change in the software variable. In order to properly debug a chip algorithm in an emulating environment as disclosed in copending Application No. 09/680,467 or in equivalent environments, it is required to monitor pin signals generated by the target interface engine in synchronization with variables of an algorithm executed by the processing engine.

Accordingly, there exists a need in the art to provide a mechanism which enables hardware pin signals generated by the target interface engine to be monitored in synchronization with variables of an algorithm executed by the processing engine in a logic chip emulation environment where the processing engine and the target interface engine interact with each other.

It is therefore an object of the present invention to provide an improved apparatus and method for verifying a logic function of a target chip which enables easy and fast debugging of the logic design of the target chip.

It is another object of the present invention to provide an improved apparatus and method for verifying a logic function of a target chip which facilitates tracking time-varying changes in software variables of the algorithm executed by a processing engine and time-varying changes in pin signals generated by a target interface engine, in a logic chip emulation environment where the processing engine and the target interface engine interact with each other.

It is still another object of the present invention to provide an improved apparatus and method for verifying a logic function of a target chip which enables hardware pin signals generated by a target interface engine to be monitored in synchronization with software variables of an algorithm executed by a processing engine, in a logic chip emulation environment where the processing engine and the target interface engine interact with each other.

According to one aspect of the present invention, an emulator for verifying a logic design of a target chip to be mounted in a target system is provided, which emulator comprises a processing engine for executing a software algorithm corresponding to the logic design of the target chip, and a target interface engine interfacing with the target system for transmitting/receiving pin signals to/from the target system in response to the execution of the software algorithm by the processing engine. Within the software algorithm, there are defined one or more software variables. The software variables and the pin signals are time-variant with the execution of the algorithm. The processing engine comprises means for finding correspondence between the software variables and the pin signals at a predetermined time.

According to another embodiment of the present invention, the target interface engine comprises a pin signal generator and a pin signal monitor. The pin signal generator generates pin signals to be transmitted to the target system and receives pin signals from the target system. The pin signal monitor receives and stores the pin signals communicated between the pin signal generator and the target system. The pin signal monitor detects an occurrence of a first trigger event defined by a predetermined combination of the values of the pin signals, and transmits a first interrupt request signal to the processing engine, in response to the occurrence of the first trigger event. Upon receiving the first interrupt request signal, the processing engine copies pin signals, which have been stored in the pin signal monitor, to a pin signal buffer.

According to yet another embodiment of the present invention, the processing engine comprises a software variable monitor for monitoring the time-varying software variable and controlling the values of the monitored software variables to be stored. The software variable monitor detects an occurrence of a second trigger event defined by a predetermined combination of the values for the time-varying software variables, and outputs a second interrupt request signal in response to the occurrence of the second trigger event. The processing engine copies pin signals, which have been stored in the pin signal monitor, to the pin signal buffer in response to the second interrupt request signal.

According to the foregoing embodiments of the present invention, information loss due to communication time delay between the processing engine and the target interface engine can be compensated. Therefore, the values of the software variables and the values of the hardware pin signals corresponding in time thereto can be monitored in synchronization with each other, and as a result, the verification of the logic function of the target chip can be made easier.

The features of the present invention which are believed to be novel are set forth with particularity in the appended claims. The present invention, both as to its organization and manner of operation, together with further objects and advantages thereof, may best be understood with reference to the following description, taken in conjunction with the accompanying drawings in which:
FIG. 1 shows a configuration of an overall system where an emulator according to the present invention is coupled to a target system;
FIG. 2 shows a detailed configuration of a processing engine of an emulator as shown in FIG. 1;
FIG. 3 shows a detailed configuration of a target interface engine of an emulator as shown in FIG. 1;
FIG. 4 shows a configuration of a memory in a processing engine as shown in FIG. 2;
FIG. 5 shows a detailed configuration of a pin signal monitor;
FIG. 6 is a view to explain a process of selecting pin signals of interest out of a plurality of pin signals by a signal selector;
FIG. 7 shows a detailed configuration of a signal sampler;
FIG. 8 shows a detailed configuration of a trigger event detector;
FIG. 9 is a flow chart explaining a series of steps to be taken by a pin signal monitor responsive to an occurrence of a hardware trigger event;
FIG. 10 is a flow chart explaining a series of steps to be taken by a processing engine upon detection of an occurrence of a hardware trigger event by a pin signal monitor;
FIG. 11 is a flow chart explaining a series of steps to be taken by a processing engine responsive to an occurrence of a software trigger event;
FIG. 12 is a timing diagram illustrating a timed relationship between monitored values of software variables and pin signals in a conventional emulator; and
FIG. 13 is a view to illustrate how to keep track of changes in a software variable to prevent loss thereof according to the present invention.

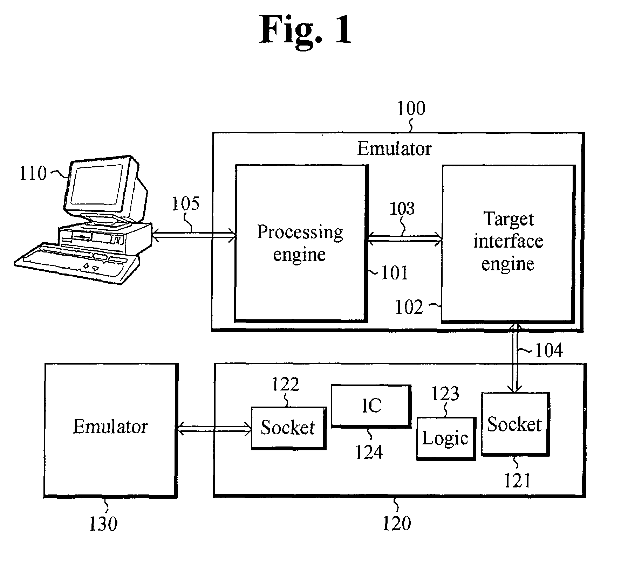

Referring to FIG. 1, there is shown an overall system where an emulator according to the present invention and a target system are coupled to each other. The emulator 100 generally comprises a processing engine 101, a target interface engine 102, and a communication channel 103 for interfacing these engines with each other such as 33MHz PCI bus or Accelerated Graphics Port (AGP). The processing engine 101 communicates with a host computer 110 through a communication port 105 such as RS-232C or USB. The target interface engine 102 is connected to a socket 121 of the target system 120, on which a target chip will be mounted eventually, through a socket adapter 104. The target chip mounted on the socket 121 is connected to other logic 123 or an integrated circuit 124 of the target system 120 to execute at least a part of the logic functions of the target system 120. As shown in FIG. 1, a target system 120 may have a plurality of target chips to be emulated. In this case, another target chip may be connected to another emulator 130 through another socket 122 of the target system 120.

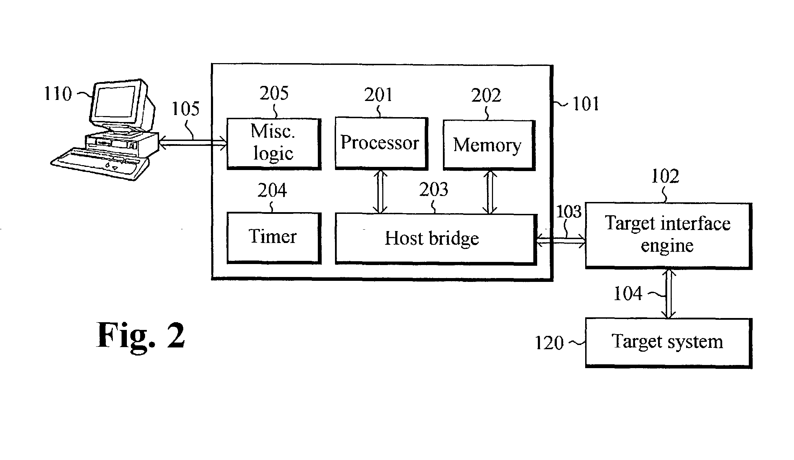

FIG. 2 shows one detailed embodiment of a processing engine in FIG. 1. The processing engine 101 includes a processor 201, a memory 202, a host bridge 203, a timer 204, and a miscellaneous logic 205. A software algorithm defining a logic function of the target chip and described in a high level language such as C/C++ or its equivalent is compiled by a host computer to an executable code. The compiled code is then downloaded through a communication port 105 and stored to the memory 202. The processor 201 in the processing engine 101 performs the application-specific internal logic function of the target chip such as signal processing, modulation/demodulation, encryption/decryption by executing the downloaded code. The processor 201 and memory 202 are connected to the target interface engine 102, which will be described later, via the host bridge 203. The miscellaneous logic 205 includes a communication port 105 and additional circuits, such as a clock generator, a voltage converter, etc. (not shown), that are needed for the processing engine 101 to operate. The timer 204 provides for accurate time information required for synchronized monitoring of pin signals and software variables, also to be explained later, and may be implemented by a counter.

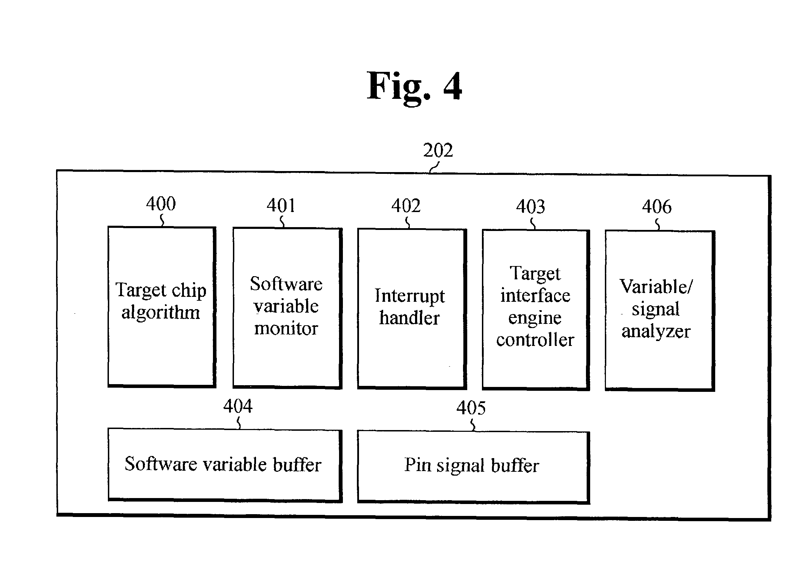

FIG. 4 shows a configuration of a memory in a processing engine as shown in FIG. 2 according to one embodiment of the present invention. The memory 202 is partitioned into several areas storing programs or data such as a target chip algorithm 400, a software variable monitor 401, an interrupt handler 402, a target interface engine controller 403, a software variable buffer 404, a pin signal buffer 405, and a variable/signal analyzer 406. The target chip algorithm 400 stores downloaded executable code relating to the internal function of the target chip. The software variable monitor 401 stores functional routines which will be inserted at the locations of the source code of the target chip algorithm where software variables to be monitored are expected to change their values. Besides the executable code for the target chip algorithm, the functional routines are also downloaded and stored in a compiled form by the host computer 110.

In case that a variable "A" is desired to be monitored in the target chip algorithm 400, the functional routine is added to or changes portions of the source code relating to the variable "A." For example, when an instruction of "A = b;" is found in the source code, that portion of the program is modified to a software routine of "SW_MONITOR(&A, b);." In one embodiment, the routine "SW_MONITOR(&A, b);" may not only assign value b to the variable "A" but also storing the value of the variable "A" as changed in the software variable buffer 404 of the memory 202. Therefore, when the processor 201 comes across this type of functional routine during the execution of the target chip algorithm 400, the changes of the variables monitored by the routine get stored in the software variable buffer 404. In this case, the software variable buffer 404 may also store timing information associated with the variable change by referencing the timer 204 (FIG. 2). In addition, in the software variable monitor 401, a user-defined software trigger condition, represented by a combination of selected variables in the target chip algorithm 400, may be set such that when the trigger condition is met, a software interrupt takes place. The software interrupt is handled by the interrupt handler 402, to be described next.

The interrupt handler 402 stores software routines that respond and handle interrupt requests occurring while the target chip algorithm 400 is executed by the processing engine 101. For example, it handles an interrupt that is generated when the values of software variables being monitored and stored in the software variable buffer 404 by the software variable monitor 401 coincide with a predetermined software trigger condition, as explained above. In addition to the software interrupt, it responds to a hardware interrupt from the target interface engine 102 defined by a combination of the values of pin signals. Further details of the interrupt handler 402 are discussed below.

The target interface engine controller 403 stores routines related to the control of the target interface engine 102. In response to the interrupt handling by the interrupt handler 402, the target interface engine controller 403 reads the values of pin signals monitored and stored by the pin signal monitor 302 of the target interface engine 102 and then stores them in the pin signal buffer 405 of the memory 202. The variable/signal analyzer 406, using information stored in the software variable buffer 404 and the pin signal buffer 405, analyzes the progress or error during emulation.

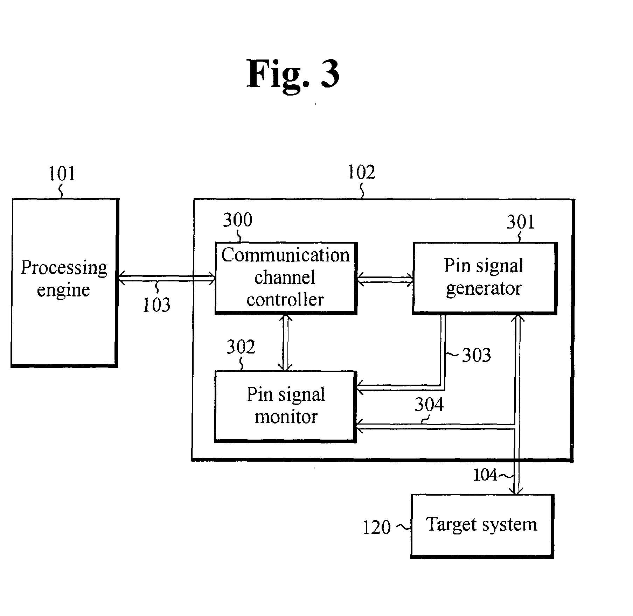

FIG. 3 illustrates an embodiment of a target interface engine according to the present invention. The target interface engine 102 comprises a communication channel controller 300, a pin signal generator 301 and a pin signal monitor 302. The pin signal generator 301 and the pin signal monitor 302 communicate with the processing engine 101 via a communication channel 103 under control of the communication channel controller 300. The pin signal generator 301 transmits/receives external pin signals such as read, write and control signals to/from the target system 120 in response to the execution of the target chip algorithm 400 by the processing engine 101. The pin signal generator 301 is a kind of logic device that is properly designed depending on the application of the target system 120 so that it communicates with logic circuits and/or integrated circuits of the target system 120. In one embodiment of the present invention, the pin signal generator 301 may be embodied in a programmable/reconfigurable chip, such as FPGA or PLD. Because the pin signal generator 301 provides the external pin signals 104 to the target system 120 as if a real chip would have, the target system 120 can properly operate as designed.

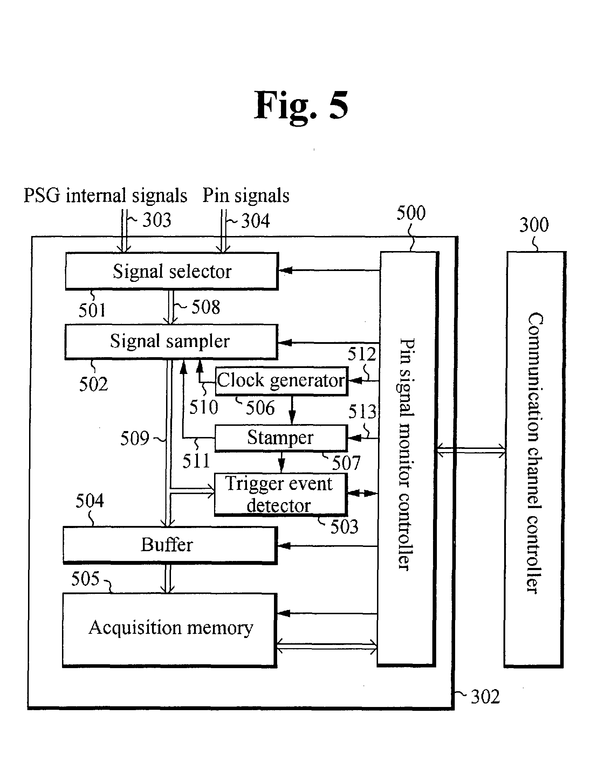

The pin signal monitor 302 receives as input the pin signals 304 being communicated between the pin signal generator 301 and the target system 120, and/or the internal pin signals 303 of the pin signal generator 301. The pin signal monitor 302 may also be embodied in a programmable/reconfigurable chip such as FPGA or PLD. As shown in more detail in FIG 5, the pin signal monitor 302 comprises a signal selector 501, a signal sampler 502, a trigger event detector 503, a buffer 504, a clock generator 506, a stamper 507, an acquisition memory 505 and a pin signal monitor controller 500. The signal selector 501 receives as input interface signals 304 between the pin signal generator 301 and the target system 120, and the internal signals 303 of the pin signal generator 301 for selecting signals that are predetermined by the user to be monitored. In other words, the signal selector 501 functions to select part of pin signals to be monitored among signals that are input to the pin signal monitor 302. What signals would be selected is decided by the user and thus may be changed according to the user's need.

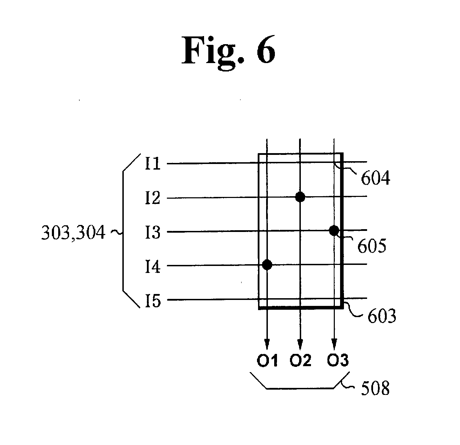

FIG. 6 schematically shows an embodiment of a signal selector which selects out three signals from 5 input signals. The user may program a reconfigurable chip such as FPGA or PLD by selectively opening/closing a plurality of connections pre-defined on a programmable area 603 of the reconfigurable chip so as to select desired input signals. Specifically, FIG. 6 shows that output lines O1, O2 and O3 are respectively coupled to input lines I4, I2 and I3. By using this kind of selector, the user can select pin signals of interest and in a desired order.

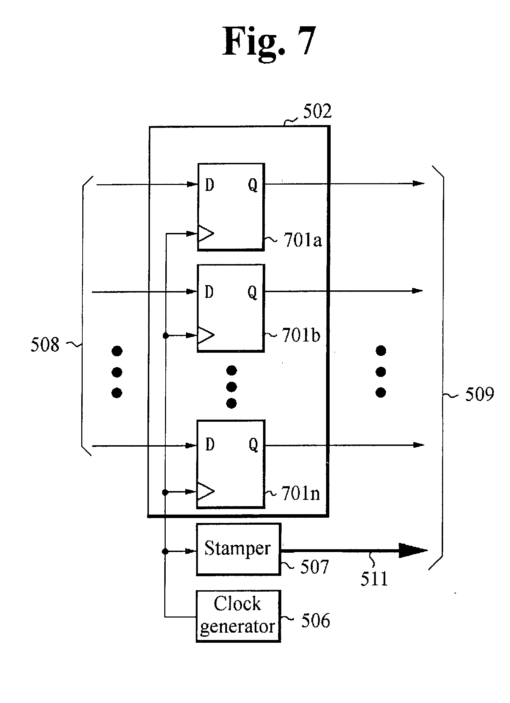

Referring back to FIG. 5, pin signals selected by the signal selector 501 are sampled by the signal sampler 502 based on a clock signal generated by the clock generator 506. As shown in FIG. 7, the signal sampler 502 comprises a plurality of flip-flops 701a-701n, where n is the number of pin signals 508 selected by the pin signal selector 501. Each flip-flop, synchronized to the clock signal of the clock generator 506, samples input pin signals 508 to produce output signals 509. In order to discriminate sampling times of sampled signals, timing information 511 generated by the stamper 507 is also included in the output signals 509 from the signal sampler 502. Preferably, a simple counter may be used as the stamper 507, which begins to count when the emulator is initialized and counts up in response to the clock signal.

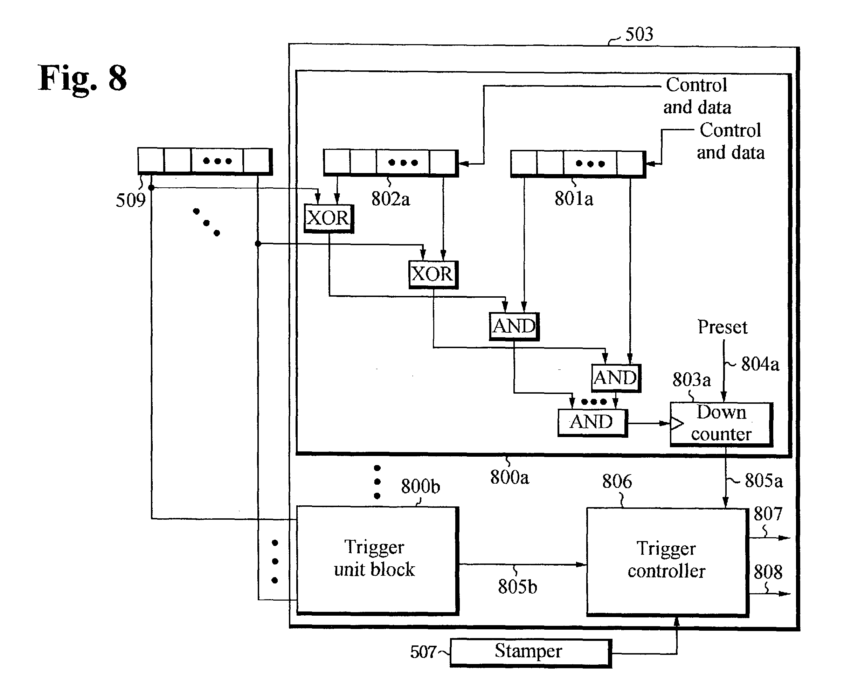

As shown in FIG. 5, the sampled pin signals 509 along with time information are temporarily stored in the buffer 504 before finally stored in the acquisition memory 505. In this way, the acquisition memory 505 stores time/stamp information as well as sampled pin signals. Therefore, it is possible to accurately locate pin signals at the time of a particular trigger event in the acquisition memory 505 by referencing stamp information 808 (see FIG. 8) which has been output at the time of that particular trigger event from a trigger event detector 503, as will be explained later, and has been stored in the memory 505 along with the associated pin signals. The buffer 504 is provided to compensate a difference between the sampling speed of the signal sampler 502 and the access speed of the acquisition memory 505. The buffer 504 may further comprise a compression function to enable the memory 505 to store more pin signal information. Preferably, the memory 505 has a circular first-in-first-out (FIFO) structure such that pin signals from the buffer 504 are sequentially stored and the oldest data is deleted to accommodate new pin signals. The memory 505 may preferably be implemented by a high-speed memory such as SRAM and may have expandability.

The sampled pin signals by the signal sampler 502 are also input to the trigger event detector 503. The detector 503 determines whether a predetermined combination of the sampled signals coincides with a trigger condition set by the user. If so, the detector 503 generates an interrupt request signal.

FIG. 8 shows an embodiment of a trigger event detector 503. The detector 503 comprises a plurality of trigger unit blocks 800a, 800b that produce event signals 805a, 805b, and a trigger controller 806 that outputs a trigger signal 807 when the sequence of event signals from the trigger unit blocks is judged to match a predetermined sequence. Each of the trigger unit blocks 800a, 800b includes a mask register 801a for designating the locations of pin signals used in a trigger condition, a pattern register 802a for designating a pattern of values for the pin signals defined as the trigger condition, and a plurality of logic gates (XOR, AND gates) for comparing the contents of the registers 801a, 802a with the sampled data 509 at the bit level. Data in the mask register 801a and pattern register 802a, used as a trigger condition are predetermined as desired by the user under control of the pin signal monitor controller 500. In this case, it should be noted that although the sampled pin signals and the contents of the pattern register 802a are compared at the bit level, the comparison results at all bit positions are not directly used for generating the event signal 805a. That is, the comparison results only at bit positions where bits of the mask register 801a are set to 1 are used for generating the event signal 805a.

Therefore, this embodiment allows certain pin signals among sampled pin signals to be used as a trigger condition. However, a trigger event detector according to the present invention is not limited to what was described above. It can have only a pattern register 802a so that the comparison results between the sampled pin signals and the contents of the pattern register at all bit positions can be used to produce an event signal. Moreover, each trigger unit block 800a, 800b may be designed to include a presettable downcounter 803a so that the event signal 805a is not generated until the number of pattern-matching events equals to the preset value of the counter 803a.

Event signals 805a, 805b generated by the trigger unit blocks 800a, 800b are input to the trigger controller 806, which determines whether the sequence of the event signals 805a, 805b matches a predetermined one and produces a final trigger signal 807 when they match. The setting of a desired sequence for the event signals can be achieved by programming a state machine in the trigger controller 806.

The trigger event detector 503, as shown in FIGs. 5 and 8, is provided with stamp information from the stamper 507 as well as the sampled pin signals 509. Thus, the trigger event detector 503 permits the processing engine 103 to precisely identify the time of occurrence of the trigger event by providing stamp information 808 at the time of the final trigger signal 807. When a trigger event occurs, the trigger signal 807 and associated stamp information 808 generated by the controller 806 are provided to the pin signal monitor controller 500, which in turn, sends an interrupt to the processing engine 101 through the communication channel controller 300. Interrupt handling by the processing engine 101 will be described later.

Referring back to FIG. 5, the pin signal monitor controller 500 of the pin signal monitor 302 communicates with the processing engine 101 through the communication channel controller 300 and controls each of the above-mentioned function blocks within the pin signal monitor 302. Specifically, the pin signal monitor controller 500 controls the signal selector 501 to designate certain pin signals that would be selected among a plurality of pin signals input to the pin signal monitor 302. The pin signal monitor controller 500 also controls the clock generator 506 and the stamper 507 by using control signals 512, 513 in order to control sampling operation of the signal sampler 502. Further, the pin signal monitor controller 500 controls the trigger event detector 503 for setting up a trigger condition, and controls the acquisition memory 505 for delivering stored pin signal information to the processing engine 101 through the communication channel controller 300.

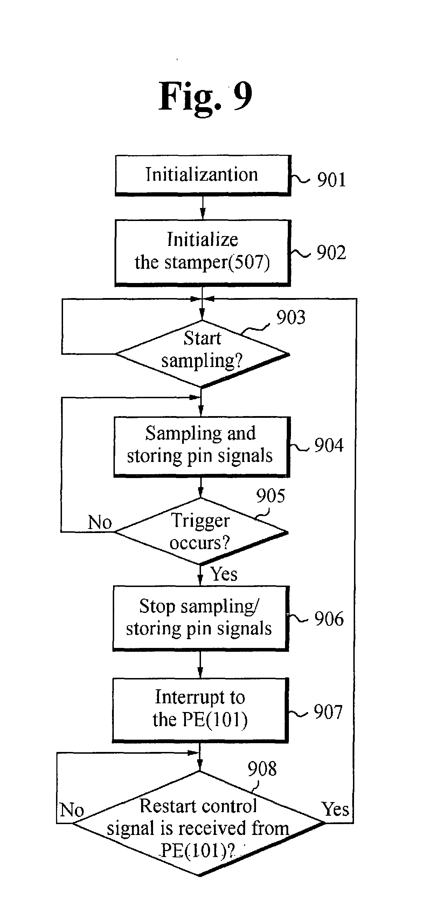

FIGs. 9-11 are, respectively, flow charts explaining a series of steps to be taken in response to a hardware trigger detected at the pin signal monitor 302 of the target interface engine 102, and a software trigger at the software variable monitor 401 of the processing engine 101.

Referring to FIG. 9, the process at the pin signal monitor 302 in response to a hardware trigger event detected by the trigger event detector 503 of the pin signal monitor 302 will be explained. First, the emulation system is initialized at step 901. Then, at step 902, the stamper 507 inside of the pin signal monitor 302 is initialized in synchronization with the timer 204 of the processing engine 101. At step 903, it is determined whether sampling of pin signals should begin. If so, at step 904, some of input/output pin signals 304 between the pin signal generator 301 and the target system 120, and internal pin signals 303 of the pin signal generator 301 are selected by the signal selector 501. The selected signals are sampled by the signal sampler 502 at rate of a clock signal provided by the clock generator 506 and stored in the buffer 504 before forwarded to the acquisition memory 505. After the sampling step 904, the sampled pin signals are examined, at step 905, by the trigger event detector 503 to see if they meet a predetermined trigger condition. If no trigger event is detected, the sampling and storing step 904 is repeated. Otherwise, the sampling is suspended at step 906 and an interrupt request to the processing engine 101 is generated at step 907. In response to the interrupt request, the processing engine 101 analyzes the values of software variables and pin signals in question and sends a control signal to reactivate the pin signal monitor 302 after the analysis. At step 908, it is determined whether the reactivating control signal was received and, if so, returning to step 903, the pin signal monitor 302 resumes sampling of pin signals.

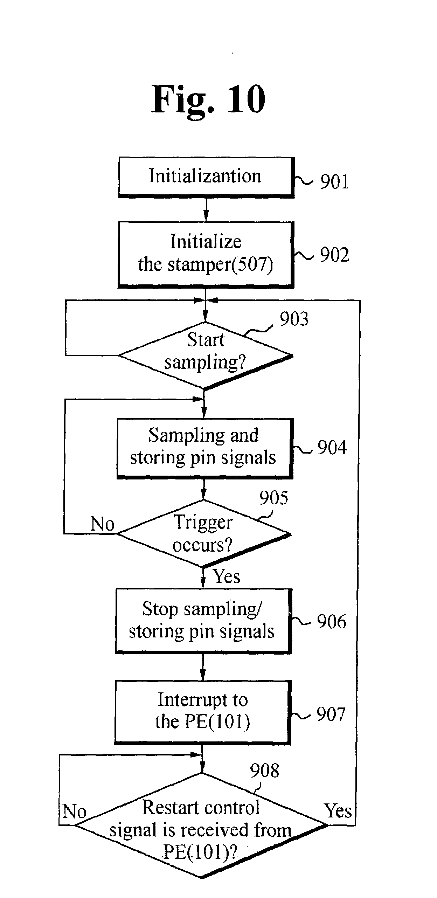

FIG. 10 illustrates a series of steps to be taken by the processing engine 101 in response to an interrupt request that follows from the detection of a hardware trigger event at the pin signal monitor 302. First, after the initialization of the emulation system at step 1000, the processor 201 in the processing engine 101 begins to execute the target chip algorithm 400 stored in the memory 202. At step 1001, the processor 201 determines whether an interrupt has been requested from the pin signal monitor 302. If positive, at step 1002, pin signal information stored in the acquisition memory 505 of the pin signal monitor 302 is copied to the pin signal buffer section 405 of the memory 202. At step 1003, the processor 201 activates the variable/signal analyzer 406 within the memory 202 to perform debugging using the contents of the software variable buffer 404 and pin signal buffer 405. Lastly, at step 1004, the processor 201 transmits a reactivating signal to the pin signal monitor 302 to be ready for a next trigger event.

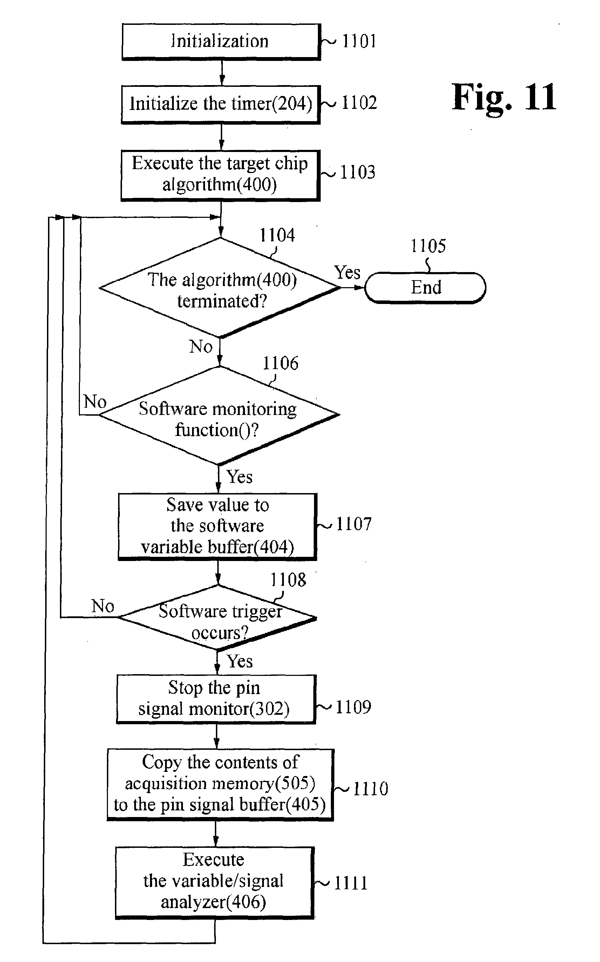

FIG. 11 illustrates a series of steps to be taken by the processing engine 101 in response to a software trigger event which may occur during the execution of the target chip algorithm 400. After the initialization of the emulation system at step 1101, the timer 204 is initialized at step 1102 and, at the same time, the stamper 507 of the pin signal monitor 302 is also initialized in synchronization with the timer 204 as explained above with reference to FIG. 9. At step 1103, the processor 201 begins to execute the target chip algorithm 400. If it is determined that the end of the algorithm is reached at step 1104, the process proceeds to step 1105 and is finished. On the other hand, if it is determined at step 1104 that the execution of the algorithm is yet not finished, the process proceeds to step 1106 where it is checked whether the processor 201 encounters a software variable monitor routine in the target chip algorithm 400. If determined that no software variable monitor routine appears at step 1106, returning to step 1103, the processor 201 proceeds with the remaining portion of the algorithm 400 and continues until a software variable routine is encountered. Otherwise, if determined that a software variable monitor routine is encountered at step 1106, the processor 201, at step 1107, executes the monitoring routine and stores the values of the software variables as monitored by the monitoring routine in the software variable buffer 404 of the memory 202. At step 1108, it is checked whether a software trigger event has occurred, based on the values of the software variables as monitored by the monitoring routine. In case of no trigger event, the processor 201 continues to execute the remaining portions of the target chip algorithm 400. If the values of the monitored software variables coincide with those predefined as a trigger condition, the sampling operation for pin signals by the pin signal monitor 302 is suspended and the pin signal information stored in the acquisition memory 505 of the pin signal monitor 302 at the event time is read and copied to the pin signal buffer 405 at step 1110. Finally, at step 1111, the processor 201 executes the variable/signal analyzer 406 within the memory 202 to perform debugging, using the contents of the software variable buffer 404 and pin signal buffer 405. After debugging, the process returns to step 1103 and the remaining portions of the algorithm 400 continue to be executed.

Next will be explained the way pin signals and software variables that are monitored at the processing engine and at the target interface engine, respectively, are saved without loss according to the present invention.

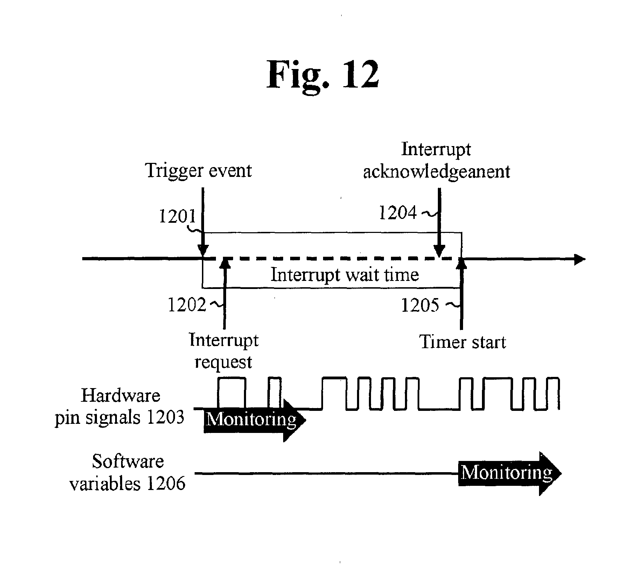

Referring to FIG. 12, there is shown a timing diagram illustrating a timed relationship between values of software variables monitored by the processing engine and hardware pin signals by the target interface engine in a conventional emulator. During the emulation, if a trigger event 1201 predefined by the user as a combination of pin signals occurs, this event is detected by the trigger event detector of the pin signal monitor, and a trigger interrupt request signal 1202 based on the detection of the trigger event is transferred to the processor of the processing engine. At the same time, the pin signal monitor begins to store all the changes 1203 in pin signals monitored after the occurrence of the trigger event in the pin signal memory. On the other hand, the processing engine does not begin to store the changes 1206 in software variables associated with the hardware trigger event in the software variable buffer until the timer for synchronization of software variables and hardware pin signals gets started after the trigger request signal 1202 is sent to the processor and an acknowledgement signal 1204 thereto is transmitted by the processor. Here, however, transmission of the interrupt request signal 1202 necessarily takes time. Moreover, even after the interrupt request signal 1202 reaches the processor, the processor cannot immediately handle the interrupt request if it was in the middle of performing a software variable monitor routine inserted in the target chip algorithm. The processor can acknowledge to the interrupt request signal 1202 only after it completes all software variable monitor routines being executed. Because of the interrupt-wait time incurred by these time delays as described, any changes in software variables during this interrupt-wait time cannot be stored. In reality, in case that the pin signal monitor and the processing engine are coupled via a PCI bus as a communication channel, the interrupt-wait time could amount to several hundreds of or, in a worst scenario, several thousands of PCI clock cycles. As a result, data loss would be disastrous.

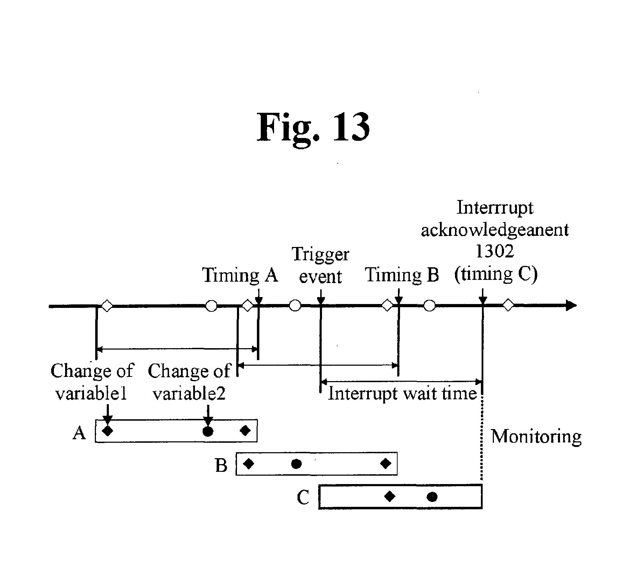

FIG. 13 illustrates how to keep track of changes in software variables in response to a hardware trigger event detected by the pin signal monitor in accordance with the present invention. The horizontal axis represents time, and circles and squares on the time axis represent changes in software variables. Horizontally extending rectangles below the time axis represent a variable recording window showing contents stored in the software variable buffer at each timing, i.e., the values of the software variables as changed prior to each timing. Specifically, window A shows contents of the software variable buffer storing the values of the software variables as changed prior to time A. Likewise, windows B and C show contents of the software variable buffer storing the values of the software variables as changed prior to times B and C, respectively. Here, the capacity of the software variable buffer, i.e., the size of windows A to C, is preferable to be such that it could record all the changes in software variables during the above described interrupt-wait time. As such, in accordance with the present invention, every time there is a change in a software variable (i.e., when a software variable monitor routine is executed), the change gets stored and updated in the software variable buffer at least during a period of time corresponding to the interrupt-wait time. Thus, any changes in the software variables during the intervening period between the detection of a trigger event 1301 and an acknowledgement thereto 1302 can be stored without loss.

Although the above description was devoted to explain a delay in monitoring software variables in case of the detection of a hardware trigger event and a solution thereto in accordance with the present invention, it should be noted that the description also applies in the same manner to a delay in monitoring hardware pin signals in case of the detection of a software trigger event. Therefore, according to the present invention, the loss of hardware pin signals during the delay period is also prevented.

As described in the foregoing, according to the present invention, in a logic chip emulation environment where the processing engine and the target interface engine interact with each other, hardware pin signals generated by the target interface engine can be monitored in synchronization with software variables within an algorithm executed by the processing engine, and therefore, total emulation time for an overall emulation system including a target system can be reduced.

While particular embodiments of the present invention have been shown and described, it will be obvious to those skilled in the art that changes and modifications may be made without departing from this invention in its broader aspects and, therefore, the aim in the appended claims is to cover all such changes and modifications, as fall within the scope of this invention.

## Claims

1. An emulator for verifying a logic design of a target chip to be mounted in a target system, comprising:
a processing engine (PE) for executing a software algorithm corresponding to the logic design of the target chip, said software algorithm having at least one software variable defined therein; and
a target interface engine interfacing with said target system for transmitting/receiving pin signals to/from said target system in response to the execution of said software algorithm by said processing engine,
wherein said at least one software variable and said pin signals are time-variant and said processing engine includes means for finding correspondence between said at least one software variable and said pin signals at a predetermined time.

2. The emulator according to claim 1, wherein said target interface engine comprises i) a pin signal generator for generating pin signals to be transmitted to said target system and receiving pin signals from said target system; and ii) a pin signal monitor for receiving and storing said pin signals communicated between said pin signal generator and said target system.

3. The emulator according to claim 2, wherein said pin signal monitor further stores time information associated with said pin signals.

4. The emulator according to claim 3, wherein said pin signal monitor comprises a trigger event detector for detecting an occurrence of a first trigger event defining a case where values of said pin signals meet a predetermined condition.

5. The emulator according to claim 4, wherein said trigger event detector further comprises means for transmitting a first interrupt request signal to said processing engine in response to the occurrence of said first trigger event.

6. The emulator according to claim 5, wherein said predetermined time is associated with the time when said first trigger event occurs.

7. The emulator according to claim 6, wherein said processing engine includes a software variable monitor for monitoring said at least one time-varying software variable and controlling values of the monitored software variables to be stored.

8. The emulator according to claim 7, wherein said software variable monitor is a software routine which is inserted into said software algorithm.

9. The emulator according to claim 7, wherein said processing engine further comprises a software variable buffer for storing said values of the monitored software variables.

10. The emulator according to claim 9, wherein said software variable buffer further stores time information associated with said values of the monitored software variables.

11. The emulator according to claim 10, wherein said processing engine responds to said first interrupt request signal after a predetermined wait time lapses from the timing when said first interrupt request signal is transmitted by said first interrupt request signal transmitting means, and wherein said software variable buffer has a buffer capacity such that it could store all the changes in said monitored software variables during said predetermined wait time.

12. The emulator according to claim 10, wherein said processing engine further comprises a pin signal buffer and means for controlling the storing of pin signals which have been stored in said pin signal monitor in said pin signal buffer in response to said first interrupt request signal.

13. The emulator according to claim 9, wherein said software variable monitor further comprises means for detecting an occurrence of a second trigger event defining a case where values of said time-varying software variables meet a predetermined condition.

14. The emulator according to claim 13, wherein said software variable monitor further comprises means for outputting a second interrupt request signal in response to the occurrence of said second trigger event.

15. The emulator according to claim 14, wherein said processing engine further comprises means for controlling the storing of pin signals which have been stored in said pin signal monitor in said pin signal buffer in response to said second interrupt request signal.

16. The emulator according to claim 12 or claim 15, wherein said processing engine further includes a variable/signal analyzer for analyzing the progress or error during emulation by using information stored in said software variable buffer and said pin signal buffer.

17. An emulator for verifying a logic design of a target chip to be mounted in a target system, comprising:
a processing engine (PE) for executing a software algorithm corresponding to the logic design of the target chip, said software algorithm having at least one software variable defined therein; and
a target interface engine interfacing with said target system for transmitting/receiving pin signals to/from said target system in response to the execution of said software algorithm by said processing engine,
wherein said at least one software variable and said pin signals are time-variant, said processing engine comprises a first means for tracking time-varying changes in said at least one software variable, and said target interface engine comprises a second means operatively coupled to said first means for tracking time-varying changes in said pin signals.

18. The emulator according to claim 17, wherein said target interface engine further comprises a pin signal generator for generating pin signals to be transmitted to said target system and receiving pin signals from said target system and said second means comprises a pin signal monitor for receiving and storing said pin signals communicated between said pin signal generator and said target system.

19. The emulator according to claim 18, wherein said pin signal monitor further stores time information associated with said pin signals.

20. The emulator according to claim 19, wherein said pin signal monitor comprises a trigger event detector for detecting an occurrence of a first trigger event defining a case where values of said pin signals meet a predetermined condition.

21. The emulator according to claim 20, wherein said trigger event detector further comprises means for transmitting a first interrupt request signal to said processing engine in response to the occurrence of said first trigger event.

22. The emulator according to claim 21, said first means comprises a software variable monitor for monitoring said at least one time-varying software variable and controlling values of said monitored software variables to be stored.

23. The emulator according to claim 22, wherein said software variable monitor is a software routine which is inserted into said software algorithm.

24. The emulator according to claim 22, wherein said first means further comprises a software variable buffer for storing said values of the monitored software variables.

25. The emulator according to claim 24, wherein said software variable buffer is controlled to further store time information associated with said values of the monitored software variables.

26. The emulator according to claim 25, wherein said first means responds to said first interrupt request signal after a predetermined wait time lapses from the timing when said first interrupt request signal is transmitted by said first interrupt request signal transmitting means, and wherein said software variable buffer has a buffer capacity such that it could store all the changes in said monitored variables during said wait time.

27. The emulator according to claim 25, wherein said first means further comprises means for controlling the storing of pin signals which have been stored in the said pin signal monitor in said pin signal buffer in response to said first interrupt request signal.

28. The emulator according to claim 24, wherein said software variable monitor further comprises means for detecting an occurrence of a second trigger event defining a case where values of said time-varying software variables meet a predetermined condition.

29. The emulator according to claim 28, wherein said software variable monitor comprises means for outputting a second interrupt request signal in response to the occurrence of said second trigger event.

30. The emulator according to claim 29, wherein said first means comprises means for controlling the storing of pin signals which have been stored in said pin signal monitor in said pin signal buffer in response to said second interrupt request signal.

31. The emulator according to claim 27 or 30, wherein said first means further includes a variable/signal analyzer for analyzing the progress or error during emulation by using information stored in said software variable buffer and said pin signal buffer.

32. A method for verifying a logic design of a target chip to be mounted in a target system, comprising the steps of:
executing a software algorithm corresponding to the logic design of the target chip, said software algorithm having at least one software variable whose value is time-variant with the execution of said software algorithm;
generating pin signals to be transmitted to said target system in response to the execution of said software algorithm, the values of said pin signals being time-variant with the execution of said software algorithm; and
providing a temporal history for changes in said at least one software variable and said pin signals.

33. The method according to claim 32, wherein said step of providing a temporal history comprises recording changes in said at least one software variable with respect to time.

34. The method according to claim 32, wherein said step of providing a temporal history comprises recording changes in said pin signals with respect to time.

35. The method according to claim 34, further comprising a step of detecting an occurrence of a first trigger event defining a case where values of said pin signals meet a predetermined condition.

36. The method according to claim 35, further comprising a step of generating a first interrupt request signal in response to the occurrence of said first trigger event.

37. The method according to claim 33, further comprising a step of detecting an occurrence of a second trigger event defining a case where values of said time-varying software variables meet a predetermined condition.

38. The method according to claim 37, further comprising a step of outputting a second interrupt request signal in response to the occurrence of said second trigger event.

39. The method according to claim 36 or 38, further comprising a step of referencing said temporal history in response to the occurrence of either said first interrupt request signal or said second interrupt request signal.

40. An emulator for verifying a logic design of a target chip to be mounted in a target system, comprising:
means for executing a software algorithm corresponding to the logic design of the target chip with at least one software variable present in said software algorithm and for transmitting/receiving pin signals to/from said target system in response to the execution of said software algorithm, wherein said at least one software variable and said pin signals are time-variant with the execution of said software algorithm; and
means for recording changes in said at least one software variable and said pin signals with respect to time for a predetermined period of time.
